Europäisches Patentamt

**European Patent Office**

**Office européen des brevets**

(19)

(11) Veröffentlichungsnummer: **0 061 647**
**B1**

(12)                          EUROPÄISCHE  PATENTSCHRIFT

(45) Veröffentlichungstag der Patentschrift:
13.02.85

(51) Int. Cl.⁴: **G 01 R  31/34,** H 02 P  7/36

(21) Anmeldenummer: **82102121.9**

(22) Anmeldetag: **16.03.82**

(54) **Vorrichtung zur Bestimmung des Läuferwinkels einer Synchronmaschine.**

(30) Priorität: **26.03.81  DE 3112010**

(43) Veröffentlichungstag der Anmeldung:
**06.10.82 Patentblatt 82/40**

(45) Bekanntmachung des Hinweises auf die Patenterteilung:
**13.02.85 Patentblatt 85/7**

(84) Benannte Vertragsstaaten:
**AT BE CH DE FR GB IT LI NL SE**

(56) Entgegenhaltungen:
**AT - B - 234 836**
**DE - B - 1 273 686**
**DE - B - 2 353 594**
**DE - B - 2 635 965**
**DE - B - 2 833 542**

(73) Patentinhaber: **Siemens Aktiengesellschaft, Berlin und
München Wittelsbacherplatz 2, D-8000 München 2 (DE)**

(72) Erfinder: **Salzmann, Theodor, Dipl.-Ing.,
Leimbergerstrasse 29, D-8520 Erlangen (DE)**
Erfinder: **Blaschke, Felix, Dr., Steinforststrasse 19,
D-8520 Erlangen (DE)**

**Beschreibung**

Die Erfindung betrifft eine Vorrichtung zur Bestimmung der auf eine raumfeste Bezugsachse bezogenen Winkellage der Läuferachse einer Synchronmaschine mittels eines Drehzahlgebers.

Für eine genaue Regelung des Drehmomentes oder der Drehzahl einer Synchronmaschine ist eine genaue Information über die momentane Lage des Läufers häufig nicht nur für den Start der Synchronmaschine, sondern auch für den weiteren Betrieb unerläßlich. (So muß z. B., um bei der Regelung des Ständerstromes einen optimalen Polradwinkel einzuhalten, die Lage des Polrades bekannt sein.) In der Regel verwendet man einen digitalen Geber, der je nach den Genauigkeitsanforderungen auf mehreren (meistens 8 oder 10) Spuren entsprechend der jeweiligen Lage des Gebers codierte Signale liefert. Diese Geber sind aufwendig und erfordern eine genaue, auf die Läuferachse abgestimmte mechanische Justierung.

Für die Drehzahlerfassung sind einfache Drehzahlgeber, z. B. Tachogeneratoren oder Inkremental-Drehgeber, entwickelt worden. Für hohe Genauigkeitsanforderungen bei der Drehzahlerfassung werden meist digitale Drehzahlgeber verwendet, deren Ausgangssignal aus einer Impulsfolge mit der Drehzahl umgekehrt proportionalen Impulsabständen besteht. Diese Drehzahlgeber liefern jedoch keine Information über den Drehwinkel der überwachten Welle, d. h. den Winkel zwischen der Läuferachse einer Synchronmaschine und einer raumfesten Bezugsachse.

Die Information über den momentanen Läuferwinkel ist besonders wichtig bei der feldorientierten Regelung, bei der durch eine Felderfassungseinrichtung aus den Motorströmen und Motorspannungen der Betrag und die Winkellage des Flußvektors erfaßt wird. Der Motorstrom und ggf. der Erregerstrom der Synchronmaschine wird nun so gesteuert, daß die das Drehmoment der Synchronmaschine bestimmende, zum Flußvektor senkrechte Komponente (Wirkkomponente) entsprechend der vorgegebenen Drehzahl bzw. dem Drehmoment gesteuert wird, während durch die Steuerung des Erregerstromes und der zum Flußvektor parallelen Motorstromkomponente der Fluß konstant gehalten wird. Gemäß der deutschen Offenlegungsschrift 2 635 965 kann zum Anfahren der Synchronmaschine der Anfangswert für den Flußwinkel dadurch erfaßt werden, daß zunächst der Motorstrom abgeschaltet bleibt und die beim Einschalten der Erregung auftretende induzierte Spannung in den Motorwicklungen erfaßt und daraus der Flußwinkel berechnet wird.

Die für die Ermittlung des Flußwinkels bei dieser Lageortung und beim anschließenden feldorientierten Betrieb verwendeten Schaltungen arbeiten mit analogen Eingangssignalen und liefern ebenfalls analoge Ausgangssignale. Bei Verwendung digitaler Periphergeräte, z. B. digitaler Winkelgeber, sind daher entsprechende Wandler nötig. Eine weitere Komplizierung tritt dadurch auf, daß die verwendeten Analogschaltungen Integratoren enthalten, die einen ermittelten Wert nur über eine verhältnismäßig kurze Zeit zu speichern vermögen.

Aus der deutschen Auslegeschrift 2 353 594 ist bereits eine Vorrichtung zur Bestimmung der auf eine raumfeste Bezugsachse bezogenen Winkellage der Läuferachse einer Synchronmaschine bekannt, die die Merkmale des Oberbegriffes des Anspruchs 1 aufweist. Der Drehzahlgeber ist dabei lage-codiert, in dem er bei jeder ganzen Läuferdrehung ein Synchronisiersignal abgibt, durch den ein als Integrator dienender Vorwärts-Rückwärts-Zähler jeweils rückgesetzt wird, der im Normalbetrieb die digitalen Impulse des Drehzahlgebers zählt.

Eine Erregungs- und Erfassungseinrichtung schaltet dabei vor dem Anlauf der Maschine während eines kurzen Meßzeitraumes bei abgeschalteten Maschinenstrom die Läufererregung vorübergehend ein und erfaßt die im Ständer induzierte Spannung. Zusätzlich ist eine an die Läuferwicklungen angeschlossene Modellschaltung vorgesehen, die einen läuferbezogenen Modellspannungsvektor berechnet. Mit Hilfe des im Vorwärts-Rückwärts-Zähler vor dem Anlauf vorhandenen, zufälligen Läuferstellungssignals wird der läuferbezogene Modellspannungsvektor in ein fiktives Ständerbezugssystem umgerechnet. Ein Vektordreher bildet die Richtungsdifferenz zwischen dem fiktiven ständerbezogenen Modellspannungsvektor und dem tatsächlich erfaßten Spannungsvektor. Eine spezielle Rechenschaltung liefert eine Differenzwinkel-Größe, aus der ein Regler Korrektursignale bildet, durch die der Zählerstand, d. h. das Läuferstellungssignal, so lange korrigiert wird, bis der fiktive Modellspannungsvektor und der tatsächliche Spannungsvektor zusammenfallen.

Bei dieser Anordnung brauchen die Analogschaltungen jeweils ihre Werte zwar nur für die kurze Meßdauer zu speichern, jedoch ist die Anordnung relativ aufwendig, da eine eigene, an die Läuferwicklung angeschlossene Modellschaltung benötigt wird, während bei der erwähnten deutschen Offenlegungsschrift 2 635 965 nur die z. B. für ein feldorientierten Betrieb ohnehin vorhandene Flußerfassungseinrichtung auf der Ständerseite vorgesehen ist. Außerdem muß der Drehzahlgeber lage-codiert sein.

Der Erfindung liegt die Aufgabe zugrunde, einen möglichst einfachen Geber für den Läuferwinkel einer Synchronmaschine anzugeben, der leicht der jeweils verwendeten Schaltung zur Steuerung der Synchronmaschine angepaßt werden kann. Zum Beispiel soll der Aufwand an Analog/Digital- und Digital/Analog-Wandlern verringert werden und es soll möglich sein, den ermittelten Läuferwinkel auch über eine längere Zeit im Stillstand oder bei langsamen Lauf der Synchronmaschine zu speichern.

Dies wird erreicht durch eine Vorrichtung der im Anspruch 1 angegebenen Art.

Weiterbildungen der Erfindung sind in den abhängigen Ansprüchen angegeben. Viele diesbezügliche Merkmale sind aus der DE-AS 2 353 594 bekannte Elemente, z. B. ein Vektordreher als Winkeldifferenz-Bestimmungsglied, das spezielle Rechenglied zur Bestimmung einer Differenzwinkelgröße, ein dem Rechenglied nachgeschalteter Regler zum Setzen des als Integrator verwendeten Zählers, Analog/Digital- und Digital/Analog-Wandler und ein Funktionsbildner zur Umwandlung des Zählerstandes in Sinus und Cosinus des Läuferwinkels. Im Gegensatz zur DE-AS 2 353 594 wird jedoch nicht ein fiktiver, auf der Läuferseite ermittelter Modellspannungsvektor auf den erfaßten Ständerspannungsvektor, sondern der Läuferwinkel auf die Richtung des ständerseitig erfaßten Flußvektors abgeglichen.

Die Erfindung und ihre vorteilhaften Weitergestaltungen sind in den Unteransprüchen gekennzeichnet und werden anhand von drei Figuren und Ausführungsbeispielen näher erläutert. Es zeigt

Fig. 1 die Grundform der Erfindung,

Fig. 2 eine vorteilhafte Ausführungsform mit einem Regler,

Fig. 3 eine teilweise digitalisierte Ausführungsform für die besonders vorteilhafte Verwendung eines nicht lagecodierten digitalen Drehgebers.

In den Figuren ist schematisch mit 1 die Synchronmaschine dargestellt, deren Motorstrom z. B. über einen Stromrichter aus einem Netz entnommen und deren Klemmenspannung U mittels eines Wandlers 2 gemessen ist. Mit 3 ist die Erregerwicklung der Synchronmaschine angedeutet. Ein mit der Läuferwelle gekoppelter Drehzahlgeber 4 liefert an seinem Ausgang 5 ein drehzahlproportionales Signal n.

Gemäß der Erfindung ist eine Lageortungseinrichtung vorgesehen, die innerhalb eines kurzen Meßzeitraumes $\Delta$t beim Aufschalten der Erregung die beim angeschalteten Maschinenstrom induzierte Spannung U mißt. Hierzu kann ein Zeitsteuerwerk 6 vorgesehen sein, das bei einem Startimpuls zum Einleiten des Lageortungsvorgangs mittels Schalter 7 und 8 die Motorwicklung und die Erregerwicklung jeweils von ihren Stromquellen trennt. Nach Schließen des Schalters 8 wird über den Spannungswandler 2 die von der aufgeschalteten Erregung induzierte Motorspannung U gemessen. In einer Rechenschaltung 9 wird aus der Spannung U ein dem Winkel $\varphi$ des erregten Flußvektors $\underline{\psi}$ entsprechendes Flußwinkelsignal gebildet, wobei dieses Signal selbst dann den ermittelten Flußwinkel $\varphi$ an dem entsprechenden Ausgang (10) über das Ende des Meßzeitraumes (z. B. einige ms) hinaus liefert, wenn die im Rechenwerk 9 verwendeten Bauelemente, insbesondere die Integratoren, z. B. aufgrund ihrer Abklingkonstanten und der Nullpunktdrift nicht in der Lage sind, einen Wert über längere Zeit zu speichern.

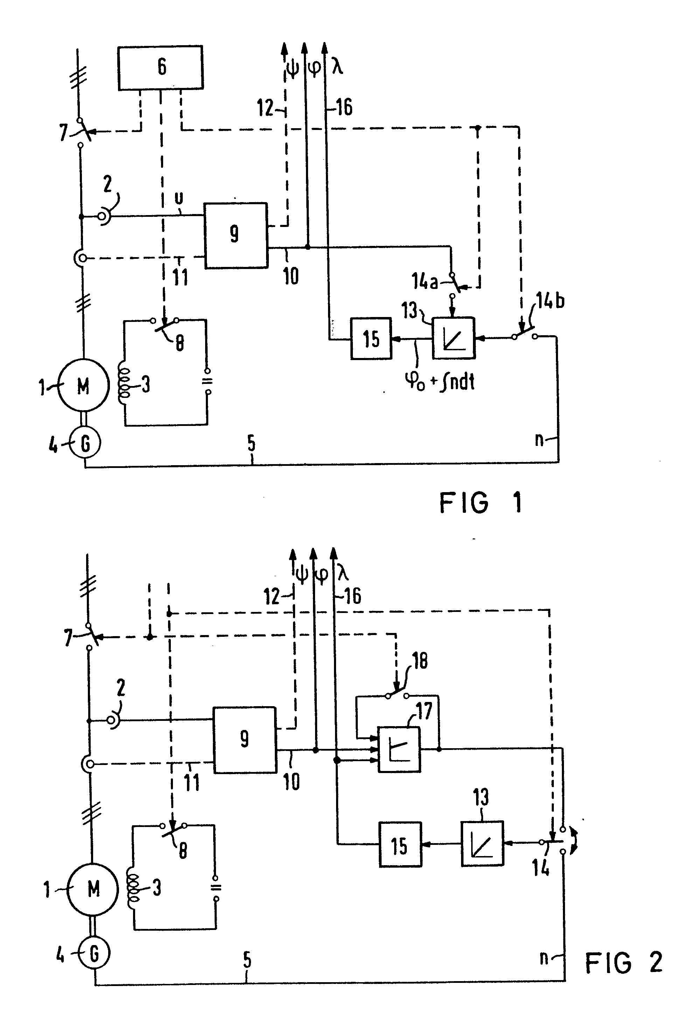

Das Prinzip einer derartigen Lageortungseinrichtung ist aus der erwähnten deutschen Offenlegungsschrift 2 635 965 bekannt. Als hierfür benötigtes Rechenwerk 9 kann insbesondere eine Schaltungsanordnung, wie sie z. B. auch für einen feldorientierten Betrieb der Drehfeldmaschine verwendet werden kann, vorgesehen sein. Für den feldorientierten Betrieb wird dabei auch der Motorstrom I gemessen, wobei das Rechenwerk 9 neben einer Information über einen Flußwinkel $\varphi$ auch den Betrag $\psi$ des Flußvektors $\underline{\psi}$ ermittelt. Die Ermittlung des Flußbetrages $\psi$ ist für das Prinzip der Erfindung nicht wesentlich, weshalb der entsprechende Meßeingang 11 für den Motorstrom und die entsprechende Ausgangsleitung 12 für den Flußbetrag $\psi$ in den Fig. 1 und 2 nur gestrichelt gezeichnet sind.

Die Erfindung beruht auf der Überlegung, daß beim Stillstand der unbelasteten Maschine Läuferachse und Feldachse zusammenfallen. Folglich kann für ein anschließendes Anlaufen der Synchronmaschine der Winkel zwischen der Feldrichtung und einer vorgegebenen, raumfesten Bezugsachse als Anfangswert für die Ermittlung des Winkels zwischen der Läuferachse und der Bezugsachse verwendet werden.

Mit dem derart ermittelten Flußwinkelsignal $\varphi$ wird nun am Ende des Meßzeitraumes ein nachgeordneter Integrator 13 gesetzt. Dazu ist der Integrator 13 über einen Schalter 14a, der ebenfalls vom Zeitsteuerwerk 6 betätigt werden kann, mindestens am Ende des Meßzeitraumes mit dem Rechenwerk 9 der Lageortungseinrichtung verbunden. Nach dem Ende des Meßzeitraumes ist dem Integrator das drehzahlproportionale Signal n des Drehzahlgebers 4 mittels eines Schalters 14b, der zusammen mit dem Schalter 14a als Umschalter ausgebildet ist, aufgeschaltet. Nach dem Ende des Meßzeitraumes steht demnach am Ausgang des Integrators 13 der Wert $\varphi_0 + \int n \cdot dt$ an.

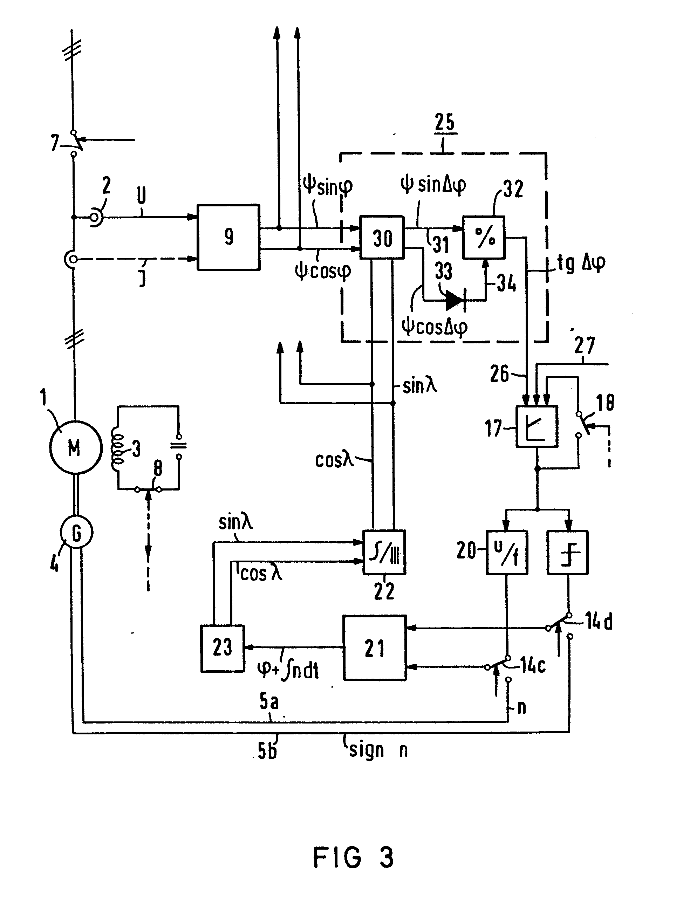

Dem Integrator 13 ist nun noch ein Funktionsbildner 15 nachgeschaltet, der aus dem Integratorausgangssignal ein Drehwinkelsignal $\lambda$ bildet. Das Flußwinkelsignal $\varphi$ kann in dem Fall, in dem der Flußvektor $\underline{\psi}$ von dem Rechenwerk 9 in Polarkoordinaten geliefert wird, der zwischen $-\pi$ und $+\pi$ liegende Flußwinkel $\varphi$ selbst sein. Der Funktionsgeber 15 ermittelt dann ein Drehwinkelsignal $\lambda$, das z. B. ebenfalls zwischen $-\pi$ und $+\pi$ entsprechend der Läuferstellung veränderlich ist. Als Flußwinkelsignal $\varphi$ und Drehwinkelsignal $\lambda$ können aber auch andere Funktionen, insbesondere Winkelfunktionen, verwendet werden, wie anhand von Fig. 3 noch erläutert werden wird. In jedem Falle liefert der Funktionsbildner ein periodisch sich änderndes Drehwinkelsignal $\lambda$, dessen Periode sich entsprechend dem Ausgangssignal des Integrators 13 ändert, wobei eine Periode des Ausgangssignals $\lambda$ bei einer zweipoligen Maschine einer Läuferumdrehung entspricht, bzw. allgemein bei einer 2p-poligen Maschine dem p-ten Teil einer Läuferumdrehung.

Am Ausgang des Funktionsbildners 15 wird das Drehwinkelsignal $\lambda$ abgegriffen. Die Leitungen 10, 12 und 16 werden der Steuerungseinrichtung für die Synchronmaschine zugeführt.

Das Setzen des Integrators 13 kann auf einfache Weise dadurch geschehen, daß dieser Integrator in einem Regelkreis angeordnet ist, der während des kurzen Meßzeitraumes den als Startwert für den Integrator zu setzenden Flußwinkel dem vom Rechenwerk 9 erfaßten tatsächlichen Flußwinkel nachführt. Hierzu ist entsprechend Fig. 2 über den Ausgang 10 des Rechenwerkes das Flußwinkel-Signal als Sollwert einem Regler 17 zugeführt, dem als Istwert das an der Leitung 16 abgegriffene Drehwinkelsignal aufgeschaltet ist. Dieser Regler 17 kann während des Meßzeitraumes mittels eines entsprechenden Freigabesignals (Schalter 18) freigegeben und außerhalb des Meßzeitraumes auf Null gesetzt werden, so daß die Aufschaltung des Flußwinkel-Signals und des Drehwinkel-Signals nur während des Meßzeitraumes wirksam ist. Das Regler-Ausgangssignal ist während des gesamten Meßzeitraumes über den Umschalter 14 dem Eingang des Integrators 13 zugeführt. Da die Zeitkonstante des Reglers sehr kurz gewählt werden kann, stellt sich am Integratorausgang bzw. dem Funktionsbildner-Ausgang sehr rasch das zum Flußwinkel gehörige Drehwinkel-Signal ein und bleibt bis zum Ende des Meßzeitraumes erhalten, der entsprechend kurz gewählt werden kann.

Ein eigenes Zeitsteuerwerk kann dann entfallen, da gegenüber dem normalen Betrieb (Schalter 7, 8 geschlossen, Integrator 17 über den Schalter 18 auf Null gesetzt) während des Meßzeitraumes lediglich die Schalter 7 und 18 offen, der Schalter 8 geschlossen und der Umschalter auf den Integratorausgang gelegt sein muß.

Diese Anordnung des Speichers im Regelkreis ist besonders vorteilhaft, wenn ein digitaler, nicht-lagecodierter Drehzahlgeber vorgesehen ist. Dem Regler 17 ist dann ein Frequenzumsetzer 20 (Fig. 3) nachgeschaltet, der eine Impulsfolge mit einer dem Reglerausgangssignal proportionalen Frequenz an einen als Integrator dienenden digitalen Vorwärts/Rückwärts-Zähler 21 abgibt. Die Zählrichtung dieses Zählers ist vom Vorzeichen des Reglerausgangssignals bestimmt. Die Aufschaltung des Drehzahlgebersignals erfolgt wieder mittels eines Umschalters, der am Ende des Meßzeitraumes den Zähleingang von der Impulsfolge des Frequenzumsetzers 20 auf die digitale Impulsfolge n (Leitung 5a) des Drehzahlgebers (Schalter 14c) und gleichzeitig vom Vorzeichen des Reglerausgangs auf das zur entsprechenden Läuferdrehrichtung gehörende Vorzeichen sign n umschaltet (Schalter 14d). Ferner ist ein Digital/Analog-Umsetzer 22 vorgesehen, der dem Integrator oder dem Funktionsbildner nachgeordnet ist. Als Funktionsbildner kann vorteilhaft ein Festwertspeicher 23 verwendet werden, der von den digitalen Ausgangssignalen des Zählers 21 angesteuert wird, wobei der Digital/Analog-Umsetzer 22 dem Funktionsbildner 23 nachgeschaltet ist. Die Ansteuerung der Speicheradressen erfolgt zyklisch, wobei ein Zyklus jeweils dem p-ten Teil einer Läuferumdrehung entspricht. Dies kann z. B. durch einen vorgeschalteten Ringzähler ermöglicht werden.

Der Funktionsbildner kann für den Fall, daß als Winkelsignal der Winkel selbst benutzt wird, eine sich mit dem Zählerstand des Zählers 21 sägezahnabartig zwischen $-\pi$ und $+\pi$ ändernde Funktion liefern. Durch entsprechende Programmierung des Festwertspeichers ist es jedoch möglich, als Drehwinkelsignal auch andere Funktionen zu verwenden, z. B. kann das Drehwinkelsignal aus zwei Einzelsignalen bestehen, die den Sinus und den Cosinus eines dem Integratorausgangssignal entsprechenden Winkels darstellen.

Nach Fig. 3 enthält vorteilhaft die bereits beschriebene teilweise digitalisierte Vorrichtung als Integrator einen digitalen Zähler 21. Diese teildigitalisierte Ausführungsform erleichtert die Startwert-Eingabe des Integrators besonders in den Fällen, bei denen das Rechenwerk 9 mit analogen Eingangs- und Ausgangssignalen arbeitet, jedoch das drehzahlproportionale Drehzahlgebersignal n digital geliefert wird. Der Regelkreis liefert letztlich den Flußwinkel als einen digitalen Startwert $\varphi_0$ für den Integrator 21. Allerdings wird als Regler 17 vorteilhaft ein Analogregler, insbesondere ein Regler mit proportionalem und integralem Anteil, verwendet, da sich dadurch besonders günstige Verhältnisse für die Zeitkonstanten des Regelkreises verwirklichen lassen. Ein besonderer Vorteil bei der Verwendung dieses Regelkreises ist, daß der Flußwinkel $\varphi$, der vom analogen Rechenwerk 9 nicht über unbegrenzte Zeit hinaus konstant zur Verfügung gestellt werden kann, am Ende des kurzen Meßzeitraumes im Zähler 21 digital gespeichert ist und somit auch nach längerem Stillstand der Maschine zur Verfügung steht.

Nach Fig. 3 ist dem Regler 17 ein Rechenglied 25 vorgeschaltet, dem mit dem Flußwinkelsignal und dem Drehwinkelsignal zwei jeweils einem Winkel entsprechende Signale zugeführt sind. Das Rechenglied bildet nun eine Differenzwinkel-Größe, die sich monoton mit der Differenz $\Delta\varphi = \varphi - \lambda$ der beiden Winkel ändert. Diese Differenzwinkel-Größe wird nun dem Istwerteingang 26 des Reglers 17 zugeführt, während dem Sollwerteingang 27 der zum Differenzwinkel $\Delta\varphi = 0$ gehörende Wert dieser Differenzwinkel-Größe aufgeschaltet ist.

In dem Fall, daß das Rechenwerk 9 den Flußvektor in seinen Polarkoordinaten, d. h. den Betrag $\psi$ und den Winkel $\varphi$, und der Funktionsbildner 23 als Drehwinkelsignal den Winkel $\lambda$ selbst liefert, kann das Rechenglied aus einer einfachen Substraktionsstufe bestehen. Werden jedoch als Flußwinkelsignal und als Drehwinkelsignal andere Funktionen von $\varphi$ und $\lambda$ verwendet, so enthält das Rechenglied vorteilhaft ein Winkeldifferenz-Bestimmungsglied 30, das aus dem Flußwinkelsignal und dem Drehwinkelsignal

0 061 647

zwei Größen bildet, von denen die erste dem Sinus des Differenzwinkels $\Delta\varphi$ proportional ist und dem Dividendeneingang 31 des Dividiergliedes 32 aufgeschaltet ist. Die zweite Ausgangsgröße des Winkeldifferenz-Bestimmungsgliedes 30 ist dem Cosinus des Differenzwinkels $\Delta\varphi$ proportional und auf ein Schwellwertglied 33 geschaltet. Dieses Schwellwertglied ist in Fig. 3 als Diode schematisch dargestellt, da es positive Eingangssignale (d. h. cos $\Delta\varphi > 0$) weitergibt, negative Werte jedoch abblockt, d. h. für cos $\Delta\varphi < 0$ den Ausgangswert 0 hat. Die Ausgangsgröße des Schwellwertgliedes wird an den Divisoreingang 34 des Dividiergliedes gelegt. Das Dividierglied 32 hat somit im Bereich $-\pi/2$ bis $+\pi/2$ einen Ausgangswert proportional zu sin $\Delta\varphi$/cos $\Delta\varphi$ = tan $\Delta\varphi$, dagegen für $\Delta\varphi < -\pi/2$ den Wert $-\infty$ und für $\Delta\varphi > +\pi/2$ den Wert $+\infty$. Das Ausgangssignal des Dividiergliedes 32 stellt also, wie für das Winkeldifferenz-Bestimmungsglied 25 allgemein gefordert ist, eine sich monoton mit dem Winkel $\Delta\varphi$ ändernde Funktion dar. Dem Sollwerteingang 27 ist in diesem Fall der zu $\Delta\varphi = 0$ gehörende Wert tg $\Delta\varphi = 0$ aufgeschaltet.

Fig. 3 betrifft insbesondere den Fall, daß das Rechenwerk 9 der Lageortungseinrichtung den Flußvektor $\psi$ in seinen kartesischen Vektorkomponenten $\psi \cdot$ sin $\varphi$, $\psi \cdot$ cos $\varphi$ bildet. Diese kartesischen Vektorkomponenten können direkt als Flußwinkel-Signal verwendet werden, wobei der Funktionsgeber 23 als Drehwinkelsignal die Funktionen sin $\lambda$ und cos $\lambda$ bereitstellt. In diesem Fall besteht das Winkeldifferenz-Bestimmungsglied 30 aus einem Vektordreher. Einem derartigen Vektordreher sind an zwei Eingängen die kartesischen Komponenten eines Vektors und an zwei anderen Ausgängen sin und cos eines Winkels eingegeben. Der Vektordreher dreht dann das Bezugssystem für den eingegebenen Vektor um den eingegebenen Winkel, so daß entsprechend Fig. 3 aus den kartesischen Koordinaten $\psi \cdot$ sin $\varphi$, $\psi \cdot$ cos $\varphi$ die Ausgangsgrößen $\psi$ sin $\Delta\varphi$ und $\psi$ cos $\Delta\varphi$ gebildet werden, wobei $\Delta\varphi$ gegeben ist durch $\varphi - \lambda$.

Die Erfindung ermöglicht es somit insbesondere, einen digitalen Zähler für die Digitalimpulse eines nicht-lagecodierten Drehzahlgebers auf einen Startwert zu setzen, der einem durch seinen Sinuswert und seinem Cosinuswert vorgegebenen Winkel entspricht. Dadurch kann der für die Steuerung der Synchronmaschine erforderliche Läuferwinkel in der geforderten Weise, insbesondere als Analogwert, zur Verfügung gestellt werden, wobei außer den ohnehin für die Steuerung der Drehzahl der Maschine benötigten Bauteilen, wie z. B. das Rechenwerk 9, nur wenige zusätzliche elektronische Bauteile erforderlich sind.

**Patentansprüche**

1. Vorrichtung zur Bestimmung der auf eine raumfeste Bezugsachse bezogenen Winkellage der Läuferachse einer Synchronmaschine (1, 3) mit

a) einem Drehzahlgeber (4), der ein zur Läufer-Drehzahl proportionales Signal (n) erzeugt,

b) einer Erregungs- und Erfassungseinrichtung (2, 8, 9), die innerhalb eines kurzen Meßzeitraumes bei abgeschaltetem Maschinenstrom (I) die Erregung (3) aufschaltet und die induzierte Spannung (U) mißt,

c) einem nachgeordneten Integrator (21), dem mindestens am Ende des Meßzeitraumes ein aus der induzierten Spannung abgeleitetes Signal und nach dem Ende des Meßzeitraumes das drehzahlproportionale Signal (n) des Drehzahlgebers zugeführt ist, und

d) einem dem Integrator (21) nachgeschalteten Funktionsbildner (23), an dessen Ausgang ein sich mit dem Integrator-Ausgangssignal $(\varphi + \int n \cdot dt)$ periodisch änderndes Dreh-Winkelsignal (sin $\lambda$, cos $\lambda$) abgegriffen ist (Fig. 3),

dadurch gekennzeichnet, daß die Erregungs- und Erfassungseinrichtung als Lageortungseinrichtung ausgebildet ist, die aus der ständerseitig induzierten Spannung ein dem Winkel des erregten Flußvektors $(\psi)$ entsprechendes Flußwinkelsignal ($\psi$ sin $\varphi$, $\psi$ cos $\varphi$) bildet und dieses Signal wenigstens bis zum Ende des Meßzeitraumes speichert, und daß Ansteuermittel (14c, 14d) vorgesehen sind, durch die der Integrator (21) so angesteuert wird, daß er am Ende des Meßzeitraumes auf einen dem Flußwinkel-Signal entsprechenden Winkelwert $(\varphi)$ gesetzt ist.

2. Vorrichtung nach Anspruch 1, dadurch gekennzeichnet, daß das Flußwinkel-Signal ($\psi$ sin $\varphi$, $\psi$ cos $\varphi$) und das Drehwinkelsignal (sin $\lambda$, cos $\lambda$) während des Meßzeitraumes einem Regler (17) zugeführt sind, dessen Ausgangssignal über die Ansteuermittel (14c, 14d) dem Integrator (21) während des Meßzeitraumes zugeführt ist.

3. Vorrichtung nach Anspruch 2, dadurch gekennzeichnet, daß dem Regler (17) ein Frequenzumsetzer (20) nachgeordnet ist, daß der Drehzahlgeber (4) ein digitaler, nicht lage-codierter Drehzahlgeber und der Integrator (21) ein digitaler Vorwärts/Rückwärtszähler ist, dessen Zählrichtung vom Vorzeichen des Regler-Ausgangssignals bestimmt ist, und daß dem Integrator oder dem Funktionsbildner ein Digital-Analog-Umsetzer (22) nachgeordnet ist (Fig. 3).

4. Vorrichtung nach Anspruch 3, dadurch gekennzeichnet, daß der Funktionsbildner (23) ein mit einer einer Läuferumdrehung entsprechenden Periode zyklisch angesteuerter Festwertspeicher ist, dem der Digital-Analog-Umsetzer (22) nachgeschaltet ist.

5. Vorrichtung nach einem der Ansprüche 2 bis 4, dadurch gekennzeichnet, daß dem Istwert-Eingang des Reglers (17) ein Rechenglied (25) vorgeschaltet ist, das aus dem Flußwinkel-Signal ($\psi$ sin $\varphi$, $\psi$ cos $\varphi$) und dem Drehwinkelsignal (sin $\lambda$, cos $\lambda$) eine Differenzwinkelgröße bildet,

5

die sich monoton mit der Differenz $\Delta\varphi$ der dem Startwinkel-Signal und dem Winkelsignal entsprechenden Winkel $(\varphi, \lambda)$ ändert, und daß dem Sollwert-Eingang (27) des Reglers der zum Differenzwinkel $\Delta\varphi=0$ gehörende Wert (tg $\Delta\varphi=0$) dieser Differenzwinkel-Größe aufgeschaltet ist.

6. Vorrichtung nach Anspruch 5, dadurch gekennzeichnet, daß das Rechenglied (25) ein Winkeldifferenz-Bestimmungsglied (30) enthält, das aus dem Flußwinkel-Signal ($\psi\sin\varphi$, $\psi\cos\varphi$) und dem Drehwinkelsignal (sin $\lambda$, cos $\lambda$) eine dem Sinus des Differenzwinkels $\Delta\varphi$ proportionale, dem Dividendeneingang (31) eines Dividiergliedes (32) aufgeschaltete erste Größe ($\psi\sin\Delta\varphi$) und eine dem Cosinus des Differenzwinkels $\Delta\varphi$ proportionale, einem Schwellwertglied (33) aufgeschaltete zweite Größe ($\psi\cos\Delta\varphi$) bildet, daß das Schwellwertglied (33) für cos $\Delta\varphi>0$ die zweite Größe und für cos $\Delta\varphi<0$ den Wert Null an den Divisoreingang (34) des Dividiergliedes (32) legt und die Ausgangsgröße (tg $\Delta\varphi$) des Dividiergliedes (32) als Differenzwinkelgröße dem Regler (17) zugeführt ist.

7. Vorrichtung nach Anspruch 6, dadurch gekennzeichnet, daß die Lageortungs-Einrichtung (9) als Flußwinkel-Signal die kartesischen Vektorkomponenten ($\psi\sin\varphi$, $\psi\cos\varphi$) des erregten Flußvektors bildet, der Funktionsgeber (23) als Winkelsignal Sinus und Cosinus eines dem Integratorausgangssignal entsprechenden Winkels ($\lambda$) bildet und als Winkeldifferenz-Bestimmungsglied (30) ein Vektordreher vorgesehen ist.

8. Vorrichtung nach einem der Ansprüche 2 bis 7, dadurch gekennzeichnet, daß der Regler ein Analog-Regler, insbesondere ein Analog-Regler mit p- und I-Anteil, ist.

## Claims

1. A device for determining the angular position, relative to a fixed reference angle, of the rotor axis of a synchronous machine (1, 3) with

a)     an impulse transmitter (4) which generates a signal (n) which is proportional to the rotor revolution rate,

b)     an energising — and detecting device (2, 8, 9) which, within a short measurement period, when the machine current (I) is disconnected switches on the excitation unit (3) and measures the induced voltage (U),

c)     a following integrator (21) which, at least at the end of the measurement period, is supplied with a signal derived from the induced voltage and at the end of the measurement period is supplied with the signal (n) of the impulse transmitter which is proportional to the revolution rate, and

d)     a function forming device (23) which is connected following the integrator (21) and from whose output there is tapped a rotation-angle signal (sin $\lambda$, cos $\lambda$) which changes periodically with the integrator output signal ($\psi+\int n \cdot dt$) (Fig. 3),

characterised in that the energising and detecting — device is designed as a location-finding device which, from the voltage induced on the stator side, forms a flux angle signal ($\psi\sin\psi$, $\psi\cos\psi$) which corresponds to the angle of the excited flux vector ($\psi$) and stores this signal at least until the end of the measurement period, and that drive means (14c, 14d) are provided which drive the integrator (21) in such manner that at the end of the measurement period it is set at an angular value ($\psi$) which corresponds to the flux angle signal.

2. A device as claimed in claim 1, characterised in that the flux angle signal ($\psi\sin\psi$, $\psi\cos\psi$) and the rotation-angle signal (sin $\lambda$, cos $\lambda$) are fed during the measurement period to a regulator (17) whose output signal is fed via the drive means (14c, 14d) to the integrator (21) during the measurement period.

3. A device as claimed in claim 2, characterised in that the regulator (17) is followed by a frequency converter (20), that the impulse transmitter (4) comprises a digital, non-position-coded impulse transmitter, and the integrator (21) comprises a digital forwards/backwards counter whose counting direction is determined by the sign of the regulator output signal, and that the integrator or the function forming device is followed by a digital-analogue converter (22) (Fig. 3).

4. A device as claimed in claim 3, characterised in that the function forming device (23) comprises a ROM which is driven cyclically with a period corresponding to a rotor rotation and which is followed by the digital-analogue converter (22).

5. A device as claimed in one of the claims 2 to 4, characterised in that the actual-value-input of the regulator (17) is preceded by a calculating element (25) which, from the flux angle signal ($\psi\sin\psi$, $\psi\cos\psi$) and the rotation-angle signal (sin $\lambda$, cos $\lambda$) forms a difference-angle value which changes monotonically with the difference ($\Delta\psi$) between the angles ($\psi, \lambda$) corresponding to the start-angle signal and the angle signal, and that the value (tg $\Delta\psi=0$) of this difference-angle value, which is assigned to the difference-angle $\Delta\psi=0$ is imposed upon the theoretical-value-input (27) of the regulator.

6. A device as claimed in claim 5, characterised in that the calculating element (25) includes an angle-difference-determining element (30) which, from the flux-angle signal ($\psi\sin\psi$, $\psi\cos\psi$) and the rotation-angle signal (sin $\lambda$, cos $\lambda$) forms a first value ($\psi\sin\Delta\psi$) which is proportional to the sine of the difference-angle $\Delta\psi$ and is imposed upon the dividend input (31) of a divider (32), and forms a second value ($\psi\cos\Delta\psi$) which is proportional to the cosine of the difference-angle $\Delta\psi$ and is imposed upon a threshold value element (33), that for cos $\Delta\psi>0$ the threshold value element (33) applies the second value to the divisor input (34) of the divider (32)

and for cos $\Delta\psi<0$ it applies the value zero thereto, and the output value (tg $\Delta\psi$) of the divider (32) is fed as difference-angle value to the regulator (17).

7. A device as claimed in claim 6, characterised in that the location-finding device (9) forms, as a flux angle signal, the Cartesian vector components ($\psi\sin\psi$, $\psi\cos\psi$) of the excited flux vector, the function generator (23) forms, as an angle signal, the sine and cosine of an angle ($\lambda$) corresponding to the integrator output signal, and a vector rotator is provided by way of angle-difference-determining element (30).

8. A device as claimed in one of the claims 2 to 7, characterised in that the regulator is an analogue regulator, in particular an analogue regulator having a p- and I-component.

## Revendications

1. Dispositif pour déterminer la position angulaire, rapportée à un axe de référence fixé dans l'espace, de l'axe du rotor d'une machine synchrone (1, 3), comportant

a) un transmetteur de la vitesse de rotation (4), qui produit un signal (n) proportionnel à la vitesse de rotation du rotor,

b) un dispositif (2, 8, 9) d'excitation et de mesure, qui, pendant un bref intervalle de temps de mesure et alors que le courant (I) de la machine est coupé, applique l'excitation (3) et mesure la tension induite (l),

c) un intégrateur (21) monté en aval et auquel est envoyé un signal, dérivé de la tension induite, à la fin de l'intervalle de temps de mesure et le signal (n), proportionnel à la vitesse de rotation, du transmetteur de la vitesse de rotation à la fin de l'intervalle de temps de mesure et,

d) un générateur de fonctions (23) branché en aval de l'intégrateur (21) et à la sortie duquel est prélevé un signal (sin $\lambda$, cos $\lambda$) de l'angle de rotation, qui varie périodiquement avec le signal de sortie de l'intégrateur ($\varphi+\int n\cdot dt$) (figure 3),

caractérisé par le fait que le dispositif d'excitation et de mesure est réalisé sous la forme d'un dispositif de repérage de position qui, à partir de la tension induite dans le stator, forme un signal ($\psi\sin\varphi$, $\psi\cos\varphi$) de l'angle de flux, qui correspond à l'angle du vecteur de flux excité ($\psi$), et mémorise le signal au moins jusqu'à la fin de l'intervalle de temps de mesure, et qu'il est prévu des moyens de commande (14c, 14d) avec lesquels l'intégrateur (21) est commandé de telle sorte qu'il est positionné, à la fin de l'intervalle de temps de la mesure, à une valeur angulaire ($\varphi$) correspondant au signal de l'angle du flux.

2. Dispositif suivant la revendication 1, caractérisé par le fait que le signal ($\psi\sin\varphi$, $\psi\cos\varphi$) de l'angle de flux et le signal (sin $\lambda$, cos $\lambda$) de l'angle de rotation sont envoyés pendant l'intervalle de temps de mesure à un régulateur (17) dont le signal de sortie est envoyé à l'intégrateur (21) par l'intermédiaire des moyens de commande (14c, 14d), pendant l'intervalle de temps de mesure.

3. Dispositif suivant la revendication 2, caractérisé par le fait que le convertisseur de fréquence (20) est monté en aval du régulateur (17), que le transmetteur de la vitesse de rotation (4) est un transmetteur numérique de la vitesse de rotation, ne comportant pas de codage de position, et que l'intégrateur (21) est un compteur numérique progressif/régressif, dont le sens de comptage est déterminé par le signe du signal de sortie du régulateur, et qu'un convertisseur numérique/analogique (22) est branché en aval de l'intégrateur ou du générateur de fonction (figure 3).

4. Dispositif suivant la revendication 3, caractérisé par le fait que le générateur de fonctions (23) est une mémoire fixe commandée de façon cyclique avec une période correspondant à une rotation du rotor, et en aval de laquelle est branché le convertisseur numérique/analogique (22).

5. Dispositif suivant l'une des revendications 2 à 4, caractérisé par le fait qu'en amont de l'entrée de la valeur réelle du régulateur (17) se trouve branché un circuit de calcul (25) qui forme, à partir du signal ($\psi\sin\varphi$, $\psi\cos\varphi$) de l'angle du flux et du signal (sin $\lambda$, cos $\lambda$) de l'angle de rotation, une grandeur de différence angulaire qui varie de façon monotone avec la différence $\Delta\varphi$ entre les angles ($\psi$, $\varphi$) qui correspondent au signal de l'angle de départ et au signal d'angle, et que la valeur (tg $\Delta\varphi=0$), associée à l'angle de différence ($\Delta\varphi=0$), de cette grandeur de la différence angulaire est envoyée à l'entrée (27) de la valeur de consigne du régulateur.

6. Dispositif suivant la revendication 5, caractérisé par le fait que le circuit de calcul (25) contient un circuit (30) de détermination de la différence d'angle, qui forme, à partir du signal ($\psi\sin\varphi$, $\psi\cos\varphi$) de l'angle de flux et du signal (sin $\lambda$, cos $\lambda$) de l'angle de rotation, une première grandeur ($\psi\sin\Delta\varphi$) proportionnelle au sinus de la différence angulaire $\Delta\varphi$ et appliquée à l'entrée du dividende (31) d'un circuit diviseur (32) et une seconde grandeur ($\psi\cos\Delta\varphi$) proportionnelle au cosinus de la différence angulaire $\Delta\varphi$ et envoyée à un circuit à valeur de seuil (33), que le circuit à valeur de seuil (33) envoie pour cos $\Delta\varphi>0$ la seconde grandeur et pour cos $\Delta\varphi<0$ la valeur zéro à l'entrée du diviseur (34) du circuit de diviseur (32) et que la grandeur de sortie (tg $\Delta\varphi$) du circuit diviseur (32) est envoyée en tant que grandeur de la différence angulaire au régulateur (17).

7. Dispositif suivant la revendication 6, caractérisé par le fait que le dispositif (9) de repérage de position forme, en tant que signal de l'angle de flux, les composantes vectorielles cartésiennes ($\psi\sin\varphi$, $\psi\cos\varphi$) du vecteur de flux excité, que le générateur de fonctions (23) forme, comme signal d'angle, le sinus et le cosinus d'un angle ($\lambda$) correspondant au signal de sortie de l'intégrateur et qu'il est prévu un dispositif de rotation vectorielle en tant que circuit (30) de détermitation de la différence angulaire.

8. Dispositif suivant l'une des revendications 2 à 7, caractérisé par le fait que le régulateur est un régulateur analogique, notamment un régulateur analogique comportant une partie proportionnelle et une partie intégrale.

FIG 1

FIG 2

FIG 3

11